Europäisches Patentamt

(19) European Patent Office

Office européen des brevets

(11) Numéro de publication : **0 290 323 B1**

(12) **FASCICULE DE BREVET EUROPEEN**

(45) Date de publication du fascicule du brevet :
28.08.91 Bulletin 91/35

(51) Int. Cl.⁵ : **C30B 11/00**

(21) Numéro de dépôt : 88401032.3

(22) Date de dépôt : 27.04.88

(54) **Four à gradient destiné à la solidification orientée, notamment par la méthode de Bridgman.**

(30) Priorité : 27.04.87 FR 8705941

(43) Date de publication de la demande :
09.11.88 Bulletin 88/45

(45) Mention de la délivrance du brevet :
28.08.91 Bulletin 91/35

(84) Etats contractants désignés :
AT BE DE ES GB IT NL SE

(56) Documents cités :
WO-A-82/02409
FR-A- 2 154 458
PATENT ABSTRACTS OF JAPAN, vol. 7, no. 66
(C-157[1211], 18 mars 1983, & JP-A-58 22 90
(FUJITSU K.K.) 07-01-1983

(56) Documents cités :
N.T.I.S. TECHNICAL NOTES, partie H, juin
1985, Springfield, Virginla, US;
"Temperature-gradient furnace for solidification experiments"
JOURNAL OF CRYSTAL GROWTH, vol. 73, no.
2, novembre 1985, pages 211-220, Elsevier
Science Publishers B.V., Amsterdam, NL; J.M.
PARSEY et al.: "A new apparatus for the
controlled growth of single crystals by horizontal bridgman techniques"

(73) Titulaire : SOCIETE EUROPEENNE DE
PROPULSION
24 rue Salomon de Rothschild
F-92150 Suresnes (FR)

(72) Inventeur : Valentian, Dominique
Forêt de Vernon
F-27207 Vernon (FR)

(74) Mandataire : Thévenet, Jean-Bruno et al
Cabinet BEAU DE LOMENIE 55 rue
d'Amsterdam
F-75008 Paris (FR)

## Description

La présente invention a pour objet un four à gradient destiné à la solidification orientée, notamment par la méthode de Bridgman, comprenant une enceinte à l'intérieur de laquelle est introduite une cartouche contenant un échantillon à soumettre à une fusion puis à une solidification orientée pour constituer un matériau monocristallin, l'enceinte définissant successivement le long de la cartouche une zone de chauffage, une zone adiabatique et un puits de chaleur, des moyens étant prévus pour déplacer à une vitesse prédéterminée la cartouche par rapport à l'enceinte et une partie tronconique formant anneau de refroidissement étant engagée de façon amovible dans le puits de chaleur à l'intérieur de l'enceinte lors de l'introduction de la cartouche dans l'enceinte et comprenant des moyens de blocage pour permettre un coulissement de la cartouche par rapport à la partie tronconique lors d'un retrait progressif de la cartouche par rapport à l'enceinte.

La réalisation de matériaux monocristallins notamment semi-conducteurs s'effectue en général dans des fours à gradient qui peuvent être appropriés à un usage spatial et qui comprennent soit des fours multi-utilisateurs, dans lesquels différents échantillons de nature ou de dimensions différentes peuvent être successivement traités, soit des fours pour expérience unique, tels que ceux connus sous la dénomination Mephisto, qui permettent d'utiliser une zone adiabatique optimisée pour un matériau déterminé.

Dans le cas des fours multi-utilisateurs, la zone adiabatique n'est pas parfaitement adaptée à chaque échantillon et les résultats ne sont pas toujours d'une qualité suffisante. Les fours à usage unique présentent eux-mêmes un inconvénient majeur, notamment pour les applications spatiales dans la mesure où ils ne permettent pas de réaliser plusieurs solidifications orientées sur des matériaux différents.

On connait encore, par exemple par l'article de J.M. Parsey Jr. et A. Thiel paru dans la revue "Journal of crystal growth" en 1985, pp. 211-220 et intitulé "A new apparatus for the controlled Growth of single crystals by horizontal Bridgman techniques" une méthode de réalisation de matériaux mono-cristallins utilisant des fours à zone adiabatique active. Ceci permet d'adapter le four à des matériaux de nature différente tout en obtenant des résultats de bonne qualité. Toutefois, cette méthode s'avère très complexe et par là-même n'est pas adaptée à une utilisation dans l'espace.

L'invention vise à remédier aux inconvénients précités et à réaliser un four à gradient permettant d'adapter de façon simple les caractéristiques de la zone adiabatique à chaque échantillon, afin de définir ainsi un four multi-utilisateurs dont la qualité est améliorée par rapport aux fours connus de ce type et dont l'utilisation est commode, ce qui le rend en particulier utilisable dans l'espace en microgravité.

Ces buts sont atteints grâce à un four à gradient du type défini en tête de la description, caractérisé en ce que la zone adiabatique du four à gradient comprend une partie annulaire fixe externe montée de façon fixe à l'intérieur de l'enceinte, et une partie annulaire amovible, coaxiale à ladite partie annulaire fixe et montée à l'intérieur de celle-ci, et la partie annulaire amovible est constituée d'un ensemble d'éléments de conductivités thermiques différentes.

Contrairement aux fours à gradient classiques dans lesquels la zone adiabatique est monobloc, le four selon la présente invention permet de modifier de façon simple les dimensions et la composition de la zone adiabatique afin de permettre une adaptation à la fois à la dimension de la cartouche contenant l'échantillon à traiter et à la nature du matériau de l'échantillon.

De façon plus particulière, la partie annulaire amovible est rattachée à la partie tronconique de refroidissement de manière à être introduite dans la zone adiabatique avec la cartouche et à être ensuite bloquée par lesdits moyens de blocage pour permettre un coulissement de la cartouche par rapport à la partie annulaire amovible lors du retrait progressif de la cartouche par rapport à l'enceinte.

De préférence, les différents éléments de la partie annulaire amovible comprennent au moins deux anneaux de conductivités thermiques différentes juxtaposés dans le sens axial de la cartouche.

Les différents éléments de la partie annulaire amovible peuvent aussi comprendre au moins deux anneaux coaxiaux de conductivités thermiques différentes juxtaposés dans le sens radial.

Avantageusement, la partie annulaire amovible comprend au moins deux éléments juxtaposés alignés axialement dont les conductivités thermiques sont dans le rapport de celles des phases solide et liquide de l'échantillon placé dans la cartouche et dont l'interface est située au niveau de l'interface liquide-solide de l'échantillon, de manière à constituer un anneau de garde vis-à-vis de l'échantillon.

D'autres caractéristiques et avantages de la présente invention ressortiront de la description de modes particuliers de réalisation, donnés à titre d'exemples, en référence aux dessins annexés, sur lesquels :

— la figure 1 est une vue schématique en coupe axiale d'un four classique à tirage selon la méthode de Bridgmann,

— la figure 2 est une vue schématique en coupe axiale d'une partie de four à tirage conforme à l'invention comprenant une zone adiabatique segmentée,

— la figure 3 est une vue d'une cartouche équipée d'un jeu de pièces amovibles constituées par un anneau de refroidissement et une partie d'une zone adiabatique d'un four à gradient selon la présente invention, le jeu de pièces amovibles étant représenté d'une part en position de début de tirage et d'autre part en position de fin de tirage,

— la figure 4 est une vue en coupe axiale d'une partie d'un four selon l'invention montrant le puits de chaleur et la partie amovible de la zone adiabatique, pour une adaptation à une cartouche de grand diamètre,

— la figure 5 est une vue en coupe axiale d'une partie d'un four selon l'invention montrant le puits de chaleur et la partie amovible de la zone adiabatique, pour une adaptation à une cartouche de petit diamètre,

— la figure 6 est une représentation schématique, en coupe axiale, d'une zone adiabatique de four traditionnel montrant les lignes de flux thermique au sein de l'échantillon et le front de fusion de l'échantillon, et

— la figure 7 est une représentation schématique, en coupe axiale, d'une zone adiabatique segmentée de four selon l'invention, montrant les lignes de flux thermique au sein de l'échantillon et le front de fusion de l'échantillon.

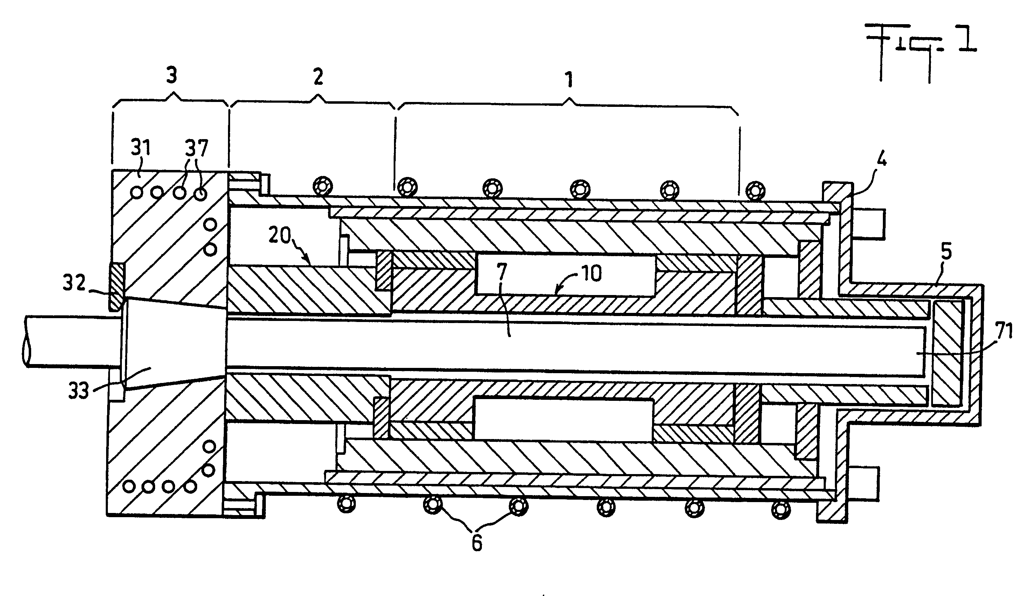

On voit sur la figure 1 un exemple de four à tirage classique permettant de réaliser des matériaux monocristallins notamment semi-conducteurs, selon la méthode de Bridgman. Un tel four comprend une enceinte 4 à l'intérieur de laquelle on introduit une cartouche 7 contenant le matériau devant faire l'objet d'une fusion puis d'une solidification.

Le four comprend essentiellement une zone de chauffage 1, une zone adiabatique 2 et une zone de refroidissement 3 qui se répartissent dans cet ordre depuis l'extrémité 5 du four opposée à l'extrémité du four par laquelle est introduite puis retirée la cartouche 7.

La zone de chauffage 1 comprend des moyens de chauffage 10, par exemple électrique permettant de faire entrer un flux de chaleur dans l'échantillon à fondre. Des moyens 6 de refroidissement des parois externes du four sont disposés autour de l'enceinte 4 au niveau de la zone de chauffage 1 et de la zone adiabatique 2. Ces moyens de refroidissement peuvent comprendre par exemple des conduits disposés en hélice autour de l'enceinte 4 et parcourus par un fluide de refroidissement.

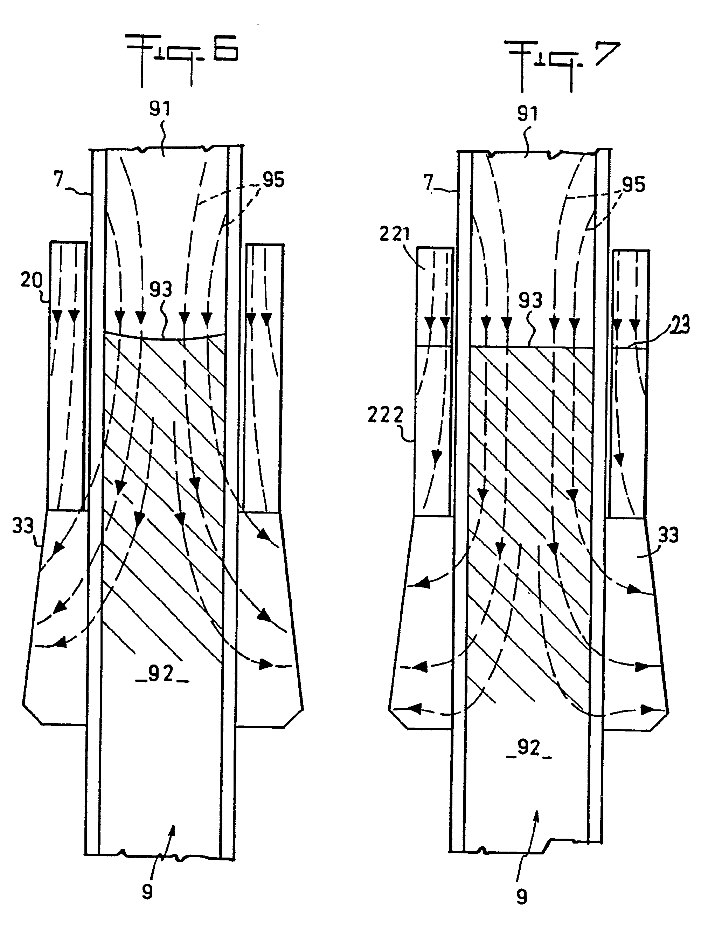

La zone adiabatique 2 comprend un bloc 20 disposé autour de la cartouche 7 et destiné à conférer au flux thermique à l'intérieur de l'échantillon 9 un caractère essentiellement unidirectionnel (Fig 6). Le front de solidification 93 qui constitue l'interface entre la phase liquide 91 de l'échantillon formée dans la zone de chauffage 1 et la phase solide 92 formée grâce à l'influence de la zone de refroidissement 3, est situé à l'intérieur de la zone adiabatique 2. La planéité du front de solidification 93 et la diminution corrélative de la quantité de défauts dans le monocristal produit seront d'autant meilleures que le caractère unidirectionnel du flux thermique 95 sera plus marqué.

La zone de refroidissement 3 ou puits de chaleur peut être couplée radiativement ou conductivement à la cartouche 7 et peut comprendre un bloc 31 percé de canaux 37 à l'intérieur desquels circule un liquide de refroidissement tel que de l'eau. Un anneau de refroidissement 33 de forme tronconique coaxial à la cartouche 7 peut être introduit dans la zone de refroidissement 3 à l'intérieur du bloc 31 lors de l'introduction de la cartouche 7 à l'intérieur du four. Une cale amovible 32 permet alors d'immobiliser l'anneau 33 à l'intérieur du bloc 31 lors du retrait de la cartouche 7 en cours de l'opération de tirage proprement dite qui permet de réaliser une solidification de l'échantillon fondu par déplacement relatif contrôlé de la cartouche 7 par rapport à la zone de chauffage 1.

La cartouche 7 est de forme essentiellement tubulaire et se trouve obturée à son extrémité froide tandis que l'autre extrémité 71 est compatible avec l'utilisation de dispositifs classiques de compensation de volume (par exemple de type ressort et piston) nécessités par les différences de densité entre la phase liquide et la phase solide.

En pratique, la zone adiabatique n'assure pas parfaitement son rôle et cela introduit une déformation du front de solidification comme cela est représenté sur la figure 6.

Grâce à la présente invention, cette déformation peut être réduite dans la mesure où une partie 22 du bloc 20 de la zone adiabatique 2 est amovible et adaptable à chaque échantillon.

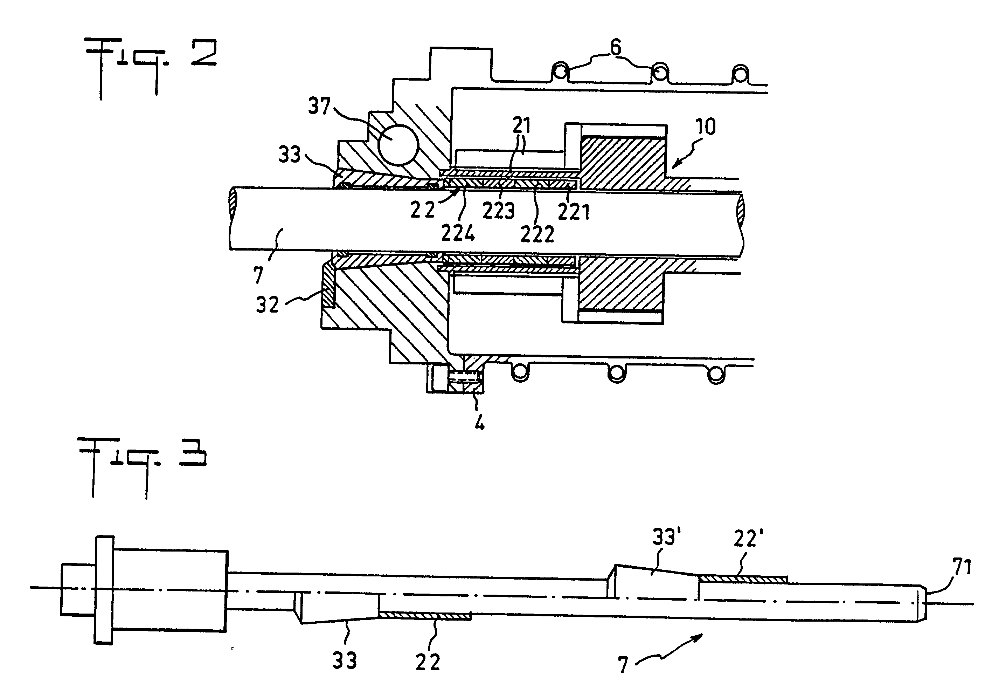

Comme on peut le voir sur la figure 2, selon la présente invention, le bloc 20 de la zone adiabatique 2 est divisé en une première partie externe 21 qui est en permanence solidaire du four et en une seconde partie 22 amovible coaxiale et interne à la première partie. La seconde partie amovible 22 est introduite dans la zone adiabatique 2 avec chaque échantillon à fondre et permet d'adapter la zone adiabatique 2 à la fois au diamètre de la cartouche 7 et à la conductivité thermique de l'échantillon à fondre.

De façon plus particulière, la partie amovible interne est segmentée et réalisée en un ensemble d'éléments 221, 222, 223, 224 de conductivités thermiques différentes. Ceci permet une adaptation de la zone adiabatique 2 à la variation de la conductivité thermique de l'échantillon entre la phase liquide et la phase solide.

On sait en effet que la conductivité thermique $\lambda_L$ de la phase liquide 91 d'un échantillon 9 est différente de la conductivité thermique $\lambda_S$ de la phase solide 92 de ce même échantillon. Pour un four de géométrie déterminée, la position du front de solidification 93 est connue par rapport au four.

Par suite, la mise en oeuvre au sein de la zone adiabatique 2 d'un anneau amovible interne 22 comprenant au moins deux éléments 221, 222 disposés à la suite l'un de l'autre et juxtaposés selon un plan radial permet de définir un front de solidification particulièrement plan (Fig 7). Pour cela, il convient de choisir deux éléments 221, 222 juxtaposés le long de l'axe de la cartouche 7 qui présentent des conductivités thermiques $\lambda_C$, $\lambda_F$ respectivement qui sont dans le rapport de celles des phases liquide et solide 91, 92 de l'échantillon 9 en face desquelles ils sont situés, et dont l'interface 23 est située pendant l'utilisation au niveau de l'interface liquide/solide 93 dont la position est prédéterminée en fonction des caractéristiques géométriques du four. La partie annulaire amovible 22 de la zone adiabatique 2 constitue ainsi un anneau de garde vis-à-vis de l'échantillon.

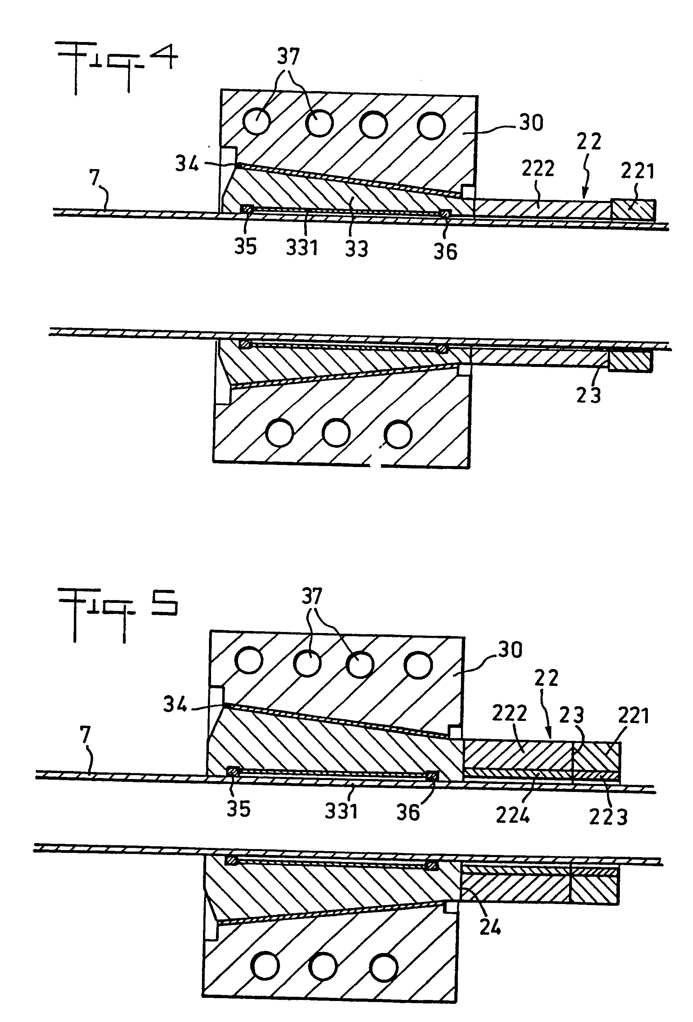

Les éléments 221, 222, 223, 224 constitutifs de la partie annulaire amovible 22 peuvent être constitués par des céramiques ou des métaux en forme de douilles juxtaposées dans le sens axial (par exemple éléments 221, 222 des figures 4 et 5, éléments 223 et 224 de la figure 5) ou juxtaposées dans le sens radial (éléments 221 et 223 d'une part et éléments 222 et 224 d'autre part sur la figure 5). Les divers éléments 221, 222, 223, 224 en forme de douilles sont constitués de plusieurs matériaux distincts liés les uns aux autres par exemple par un ciment réfractaire ou un adhésif haute température. En fonction des conductivités thermiques différentes des matériaux des divers éléments 221, 222, 223, 224 constituant une partie amovible 22, il est possible de redresser les lignes 95 de flux thermique à l'intérieur de l'échantillon et de compenser de façon complète les différences de conductivité thermique de phases liquide et solide de l'échantillon.

Dans la mesure où la position et la forme du front de fusion sont conditionnées exclusivement par les caractéristiques des trois zones 1, 2, 3 du four et en particulier par les caractéristiques de la zone adiabatique 2, une fois la position du front de fusion 93 déterminée par le calcul, la segmentation de la partie amovible 22 de la zone adiabatique peut être réalisée avec une grande précision.

Par ailleurs, la mise en oeuvre d'une partie annulaire amovible 22 dans la zone adiabatique 2 permet de modifier la longueur de cette zone en réalisant une partie interne 22 qui se prolonge un peu au-delà de la partie externe 21 dans la zone de chauffage 1 afin de diminuer le gradient, dans le cas où les matériaux de l'échantillon sont particulièrement fragiles.

Comme on peut le voir sur les figures 4 et 5, la partie amovible 22 de la zone adiabatique 2 et l'anneau de refroidissement 33 peuvent être adaptés à des diamètres de cartouche différents et permettent ainsi d'essayer des échantillons de diamètres différents dans un même four.

La figure 4 concerne la mise en oeuvre d'une cartouche de grand diamètre avec une partie amovible interne 22 de relativement faible épaisseur comprenant deux segments 221 et 222, et un anneau de refroidissement 33 également de relativement faible épaisseur qui est placé à l'intérieur du corps 30 du puits de chaleur muni d'un circuit 37 de circulation d'eau de refroidissement. L'anneau de refroidissement définit autour de la cartouche 7, de façon connue en soi, un anneau de métal liquide 331 dans un espace annulaire délimité par deux joints 35, 36 placés aux deux extrémités de l'anneau de refroidissement 33. Un joint thermique 34 est également disposé à la jonction entre le corps 30 et l'anneau 33 du côté opposé à la zone adiabatique.

La figure 5 concerne la mise en oeuvre d'une cartouche de petit diamètre et présente ainsi une partie amovible interne 22 de relativement forte épaisseur qui, à titre d'exemple, comprend quatre segments 221 à 224. L'anneau de refroidissement est également plus épais que dans le cas de la figure 4 tout en présentant la même structure.

Comme cela a été représenté sur les figures 4 et 5, il est possible d'utiliser avec un même four plusieurs jeux de pièces 22, 33 présentant des parois externes de configuration et de dimensions identiques et des parois internes de configuration ou de dimensions différentes pour assurer l'adaptation de cartouches 7 ayant des diamètres différents, chaque jeu de pièces comprenant un anneau de refroidissement de forme tronconique 33 et une partie annulaire amovible 22 de forme cylindrique rattachée à l'anneau de refroidissement.

Comme on l'a représenté en deux demi-vues sur la figure 3, l'ensemble constitué par un anneau de refroidissement 33 et une partie amovible 22 de zone adiabatique 2 est introduit dans le four avec une cartouche 7 dans une position de début de tirage, puis la cartouche 7 est retirée progressivement du four en coulissant par rapport à l'ensemble 33, 22 qui est maintenu dans le four dans la position initiale, par exemple à l'aide de la cale 32 de la figure 2. En fin de tirage, l'ensemble 33, 22 est ainsi décalé par rapport à l'extrémité 71 de la cartouche et a été désigné sur la figure 3 en position finale du tirage par les références 33', 22'. Après la fin d'un processus de formation d'un monocristal en métal ou matériau semi-conducteur, l'ensemble 33', 22' peut être retiré facilement afin de permettre l'introduction d'une autre cartouche équipée d'un autre jeu de pièces 33, 32.

**Revendications**

1. Four à gradient destiné à la solidification orientée, notamment par la méthode de Bridgman, comprenant une enceinte (4) à l'intérieur de laquelle est introduite une cartouche (7) contenant un échantillon (9) à soumettre à une fusion puis à une solidification orientée pour constituer un matériau monocristallin, l'enceinte définissant successivement le long de la cartouche (7) une zone de chauffage (1),

une zone adiabatique (2) et un puits de chaleur (3), des moyens étant prévus pour déplacer à une vitesse prédéterminée la cartouche (7) par rapport à l'enceinte (4) et une partie tronconique (33) formant anneau de refroidissement étant engagée de façon amovible dans le puits de chaleur (3) à l'intérieur de l'enceinte (4) lors de l'introduction de la cartouche (7) dans l'enceinte (4) et comprenant des moyens de blocage (32) pour permettre un coulissement de la cartouche (7) par rapport à la partie tronconique (33) lors d'un retrait progressif de la cartouche (7) par rapport à l'enceinte (4), caractérisé en ce que la zone adiabatique (2) du four à gradient comprend une partie annulaire fixe externe (21) montée de façon fixe à l'intérieur de l'enceinte (4), et une partie annulaire (22) amovible, coaxiale à ladite partie annulaire fixe et montée à l'intérieur de celle-ci, et en ce que la partie annulaire amovible (22) est constituée d'un ensemble d'éléments (221 à 224) de conductivités thermiques différentes.

2. Four à gradient selon la revendication 1, caractérisé en ce que la partie annulaire amovible (22) est rattachée à la partie tronconique de refroidissement (33) de manière à être introduite dans la zone adiabatique (2) avec la cartouche (7) et à être ensuite bloquée par lesdits moyens de blocage (32) pour permettre un coulissement de la cartouche (7) par rapport à la partie annulaire amovible (22) lors du retrait progressif de la cartouche (7) par rapport à l'enceinte (4).

3. Four à gradient selon la revendication 1 ou la revendication 2, caractérisé en ce que les différents éléments (221 à 224) de la partie annulaire amovible (22) comprennent au moins deux anneaux de conductivités thermiques différentes (221, 222) juxtaposés dans le sens axial de la cartouche (7).

4. Four à gradient selon l'une quelconque des revendications 1 à 3, caractérisé en ce que les différents éléments (221 à 224) de la partie annulaire amovible (22) comprennent au moins deux anneaux coaxiaux de conductivités thermiques différentes (221, 223 ou 222, 224) juxtaposés dans le sens radial.

5. Four à gradient selon l'une quelconque des revendications 1 à 4, caractérisé en ce que les éléments (221 à 224) de conductivités thermiques différentes sont constitués par des céramiques et des métaux.

6. Four à gradient selon l'une quelconque des revendications 1 à 5, caractérisé en ce que la partie annulaire amovible (22) comprend au moins deux éléments juxtaposés (221, 222) alignés axialement dont les conductivités thermiques sont dans le rapport de celles des phases solide et liquide de l'échantillon (9) placé dans la cartouche (7) et dont l'interface est située pendant l'utilisation au niveau de l'interface liquide-solide de l'échantillon (9), de manière à constituer un anneau de garde vis-à-vis de l'échantillon.

7. Four à gradient selon l'une quelconque des revendications 1 à 6, caractérisé en ce que les différents éléments (221 à 224) constituant la partie annulaire amovible (22) sont liés les uns aux autres, par un ciment réfractaire ou un matériau adhésif haute température.

8. Four à gradient selon l'une quelconque des revendications 1 à 7, caractérisé en ce que la partie annulaire amovible (22) s'étend axialement au-delà de la partie annulaire fixe externe (21) dans la zone de chauffage (1).

9. Four à gradient selon l'une quelconque des revendications 1 à 8, caractérisé en ce qu'il comprend plusieurs jeux de pièces présentant des parois externes de configuration et de dimensions identiques et des parois internes de configuration ou de dimensions différentes pour assurer l'adaptation au même four de cartouches (7) ayant des diamètres différents, chaque jeu de pièces comprenant un anneau de refroidissement de forme tronconique (33) et une partie annulaire amovible interne (22) de forme cylindrique.

## Claims

1. Gradient oven for oriented solidification, in particular by the Bridgman method, comprising an enclosure (4) inside which is introduced a cartridge (7) containing a sample (9) to be melted and then solidified in oriented manner in order to constitute a monocrystalline material, the enclosure defining in succession along the cartridge (7) a heating zone (1), an adiabatic zone (2) and a heat sink (3), means being provided for moving the cartridge (7) at a predetermined speed relative to the enclosure (4) and a frustoconical portion (33) constituting a cooling ring being removably engaged in the heat sink (3) inside the enclosure (4) when the cartridge (7) is introduced into the enclosure (4) and including locking means (32) to enable the cartridge (7) to slide relative to the frustoconical portion (33) when the cartridge (7) is progressively withdrawn from the enclosure (4), characterized in that the adiabatic zone (2) of the gradient oven comprises an outer fixed annular portion (21) mounted in fixed manner inside the enclosure (4), and a removable annular portion (22) which is coaxial with said fixed annular portion and mounted inside it, and in that the removable annular portion (22) is constituted by a set of components (221 to 224) having different thermal conductivities.

2. Gradient oven according to claim 1, characterized in that the removable annular portion (22) is connected to the frustoconical cooling portion (33) in such a manner as to be inserted into the adiabatic zone (2) together with the cartridge (7) and subsequently to be locked in place by said locking means (32) in order to enable the cartridge (7) to slide relative to the removable annular portion (22) during the progressive withdrawal of the cartridge (7) relative to the enclosure (4).

3. Gradient oven according to claim 1 or claim 2, characterized in that the various components (221 to 224) of the removable annular portion (22) comprise at least two rings of different thermal conductivities (221, 222) juxtaposed in the axial direction of the cartridge (7).

4. Gradient oven according to any one of claims 1 to 3, characterized in that the various components (221 to 224) of the removable annular portion (22) comprise at least two coaxial rings of different thermal conductivities (221, 223 or 222, 224) juxtaposed in the radial direction.

5. Gradient oven according to any one of claims 1 to 4, characterized in that the components (221 to 224) of different thermal conductivities are constituted by ceramics and metals.

6. Gradient oven according to any one of claims 1 to 5, characterized in that the removable annular portion (22) comprises at least two axially aligned juxtaposed elements (221, 222) whose thermal conductivities are in the same ratio as the thermal conductivities of the solid and liquid phases of the sample (9) placed in the cartridge (7), and whose interface is situated, during use, on the level of the liquid-solid interface of the sample (9), in such a manner as to constitute a guard ring for the sample.

7. Gradient oven according to any one of claims 1 to 6, characterized in that the various components (221 to 224) constituting the removable annular portion (22) are connected to one another by a refractory cement or a high temperature adhesive material.

8. Gradient oven according to any one of claims 1 to 7, characterized in that the removable annular portion 22 extends axially beyond the outer fixed annular portion 21 into the heating zone.

9. Gradient oven according to any one of claims 1 to 8, characterized in that it comprises a plurality of sets of parts which have outer walls of identical size or shape and inner walls of different size or shape for adapting cartridges (7) of different diameters to the same oven, each set of parts including a frustoconical cooling ring (33) and a removable inner annular portion (22) of cylindrical shape.

## Patentansprüche

1. Gradientenofen, bestimmt für die gerichtete Erstarrung, insbesondere durch das Bridgman-Verfahren, mit einem Hohlraum (4), in dessen Innerem eine Kartusche (7) eingeführt ist, die ein Muster (9) enthält, das einem Schmelzen und sodann einem gerichteten Erstarren zu unterwerfen ist, um ein monokristallines Material zu bilden, wobei der Hohlraum aufeinanderfolgend entlang der Kartusche (7) eine Heizzone (1), eine adiabatische Zone (2) und eine Wärmesenke (3) definiert, wobei Einrichtungen vorgesehen sind, um die Kartusche (7) bezüglich des Hohlraums (4) und mit einer bestimmten Geschwindigkeit zu verschieben, und ein kegelstumpfförmiger Teil (33), der einen Kühlring bildet, auf bewegliche Weise in die Wärmesenke (3) im Inneren des Hohlraums (4) beim Einführen der Kartusche (7) in den Hohlraum (4) eingreift und Blockierungseinrichtungen (32) umfasst, um eine Gleitbewegung der Kartusche (7) bezüglich des kegelstumpfförmigen Teils (33) bei einem allmählichen Zurückziehen der Kartusche (7) bezüglich des Hohlraums (4) zu erlauben, **dadurch gekennzeichnet,** dass die adiabatische Zone (2) des Gradientenofens einen festen äusseren ringförmigen Teil (21) aufweist, der fest im Inneren des Hohlraums (4) angebracht ist, und einen beweglichen ringförmigen Teil (22) aufweist, der koaxial zum festen ringförmigen Teil verläuft und im Inneren von diesem angebracht ist, und dass der bewegbare ringförmige Teil (22) aus einer Anordnung von Elementen (221-224) von unterschiedlicher Wärmeleitfähigkeit gebildet ist.

2. Gradientenofen nach Anspruch 1, **dadurch gekennzeichnet,** dass der bewegbare ringförmige Teil (22) an dem kegelstumpfförmigen Kühlteil (33) derart angebracht ist, dass er in die adiabatische Zone (2) mit der Kartusche (7) eingeführt ist und dass er danach durch die genannten Blockiereinrichtungen (32) blockiert ist, um ein Gleiten der Kartusche (7) bezüglich des bewegbaren ringförmigen Teils (22) beim allmählichen Herausziehen der Kartusche (7) bezüglich des Hohlraums (4) zu erlauben.

3. Gradientenofen nach Anspruch 1 oder 2, **dadurch gekennzeichnet,** dass die verschiedenen Elemente (221-224) des bewegbaren ringförmigen Teils (22) wenigstens zwei Ringe von unterschiedlicher Wärmeleitfähigkeit (221, 222) aufweisen, die in Axialrichtung der Kartusche (7) nebeneinander angeordnet sind.

4. Gradientenofen nach einem der Ansprüche 1 bis 3, **dadurch gekennzeichnet,** dass die verschiedenen Elemente (221-224) des bewegbaren ringförmigen Teils (22) wenigstens zwei koaxiale Ringe von unterschiedlicher Wärmeleitfähigkeit (221, 223 bzw. 222, 224) aufweisen, die in radialer Richtung nebeneinander angeordnet sind.

5. Gradientenofen nach einem der Ansprüche 1 bis 4, **dadurch gekennzeichnet,** dass die Elemente (221-224) von unterschiedlicher Wärmeleitfähigkeit durch keramische oder metallische Materialien gebildet sind.

6. Gradientenofen nach einem der Ansprüche 1 bis 5, **dadurch gekennzeichnet,** dass der bewegliche ringförmige Teil (22) wenigstens zwei nebeneinander angeordnete Elemente (221, 222) aufweist, die axial ausgerichtet sind, deren Wärmeleitfähigkeit im Verhältnis zu jenen der festen und flüssigen Phasen des Muster (9) sind, das in der Kartusche (7) angeordnet ist, und deren Zwischenfläche während der Verwendung auf der Höhe der Zwischenfläche flüssigfest des Musters (9) angeordnet ist, derart, dass ein Schutzring gegenüber dem Muster gebildet wird.

7. Gradientenofen nach einem der Ansprüche 1 bis 6, **dadurch gekennzeichnet,** dass die verschiedenen Elemente (221-224), die den beweglichen ringförmigen Teil (22) bilden, untereinander verbunden sind durch einen nicht brennbaren Zement oder einen Hochtemperaturklebstoff.

8. Gradientenofen nach einem der Ansprüche 1 bis 7, **dadurch gekennzeichnet,** dass der ringförmige bewegbare Teil (22) sich über den äusseren festen ringförmigen Teil (21) in die Heizzone (1) axial hinaus erstreckt.

9. Gradientenofen nach einem der Ansprüche 1 bis 8, **dadurch gekennzeichnet,** dass er mehrere Sätze von Teilen aufweist, die äussere Trennwände von gleicher Konfiguration und Abmessung und innere Seitenwände von unterschiedlicher Konfiguration oder Abmessung aufweisen, um die Anpassung von Kartuschen (7) mit unterschiedlichen Durchmessern an denselben Ofen sicherzustellen, wobei jeder Satz von Teilen einen Kühlring von kegelstumpfförmiger Ausbildung (33) und einen inneren bewegbaren Ringteil (22) von Zylinderform aufweist.

Fig. 1

Fig. 2

Fig. 3

EP 0 290 323 B1

Fig. 4

Fig. 5

# Fig.6

# Fig.7